# EUROPÄISCHE PATENTANMELDUNG

(11) **EP 2 388 916 A1**
(43) Veröffentlichungstag der Anmeldung: **23.11.2011**
(21) Anmeldenummer: 10011958.5
(22) Anmeldetag: 25.10.2006
(51) Int. Cl.: H03K 5/08, H03K 5/003, H03M 1/06, H04L 25/06, H04B 10/158

(54) **Verfahren und Vorrichtung zur Datenübertragung mit analogen Signalen**

(30) Priorität: 29.11.2005 DE 102005057240
(62) Teilanmeldung aus: 06022264.3
(71) Anmelder: Prof. Dr. Horst Ziegler und Partner GbR, 70499 Stuttgart (DE)
(72) Erfinder: Ziegler, Horst, 33100 Paderborn (DE); Steffens, Andreas, 33102 Paderborn (DE)
(74) Vertreter: Ostertag, Reinhard

(57) **Zusammenfassung**

Es wird eine Vorrichtung zur Datenübertragung mit wenigstens einem impulsförmigen analogen optoelektronischen Signal (20), welches die zu übertragenden Daten charakterisiert, beschrieben, wobei das analoge optoelektronische Signal (20) eine vorgegebene begrenzte Dauer-EIN-Zeit hat. Diese umfasst einen Umwandler zur Umwandlung des analogen optoelektronischen Signals (20) in ein digitales. Der Umwandler weist ein Vergleicher-Mittel (26) auf zum Vergleichen des analogen optoelektronischen Signals (20) mit einem vorgegebenen analogen Schwellwert und zur Erzeugung eines binären Ausgangssignals (34), wenn eine Amplitude des analogen optoelektronischen Signals (20) größer als der analoge Schwellwert ist. Außerdem weist der Umwandler eine steuerbare analogelektrische Signalvertauschungseinrichtung (56), mit der die Polarität des analogen optoelektronischen Signals (20) beim Erreichen einer vorgegebenen maximalen Dauer-EIN-Zeit für das binäre Ausgangssignal (34) änderbar ist, auf. Darüber hinaus wird ein entsprechendes Verfahren beschrieben.

## Beschreibung

Die Erfindung betrifft ein Verfahren zur Datenübertragung, bei dem wenigstens ein impulsförmige analoges Signal, welches die zu übertragenden Daten charakterisiert, mit vorgegebener begrenzter Dauer-ZUSTANDS-Zeit in ein digitales, insbesondere binäres, Signal umgewandelt wird.

Unter ZUSTANDS-Zeit soll hier und in den Ansprüchen eine Zeit verstanden werden, in welcher ein Signal einen vorgegebenen Zustand aufweist, der z.B. "EIN" oder "AUS" bzw. "1" oder "0" sein kann

Außerdem betrifft die Erfindung eine Vorrichtung zur Datenübertragung mit wenigstens einem impulsförmigen analogen Signal, welches die zu übertragenden Daten charakterisiert, wobei das analoge Signal eine vorgegebene begrenzte Dauer-ZUSTANDS-Zeit hat, und mit einem Umwandler zur Umwandlung des analogen signals in ein digitales, insbesondere binäres, Signal.

Unter einem analogen Signal soll in der vorliegenden Beschreibung und den Ansprüchen ein Signal verstanden werden, dessen Amplitude kontinuierlich veränderlich ist, unter einem digitalen oder binären Signal ein solches, dessen Amplitude nur einen von zwei vorgegebenen werten "0" und "1" annehmen kann.

Insbesondere bekannte Verbrauchsmessgeräte (Heizkosten-Verteiler, Wasser-, Wärme- Gas- und Stromzähler), und auch viele andersartige mobile oder ortsfeste elektronische Geräte mit Netz- oder Batteriebetrieb, weisen zur Kommunikation mit anderen, insbesondere auch mobilen Geräten, Vorrichtungen zur Datenübertragung auf. Mit diesen Vorrichtungen werden mit wenigstens einem analogen optoelektronischen Signal, insbesondere mit einem sichtbaren oder infraroten Lichtsignal in Form von Lichtimpulse, Daten übertragen. Entsprechende Sender weisen hierzu vorzugsweise Halbleiter-LED's (Light Emitting Diodes) zur Erzeugung der Lichtsignale auf. Entsprechende Empfänger umfassen optoelektronische Empfängerbauelementen, insbesondere Fotodioden, Fototransistoren, Fotowiderstände oder Fotozellen. Mit den optoelektronischen Empfängerbauelementen werden die vom Sender erzeugten Lichtsignale erfasst und in entsprechende analoge optoelektronische Spannungs- oder Strom- oder Widerstandssignale umgesetzt. Diese analogen Signale können dann verstärkt und/oder gefiltert und bei derzeit marktüblichen digitalen Daten-übertragungsvorrichtungen durch einen Schwellwertvergleich vorzugsweise unter Verwendung eines Analog-Komparators in binäre elektrische Datensignale, zur Weiterverarbeitung vorzugsweise durch einen Mikroprozessor, umgewandelt werden.

Die analogen Signale können durch Fremdsignale, hervorgerufen beispielsweise durch Tageslicht, technisches Fremdlicht, Fertigungs-Offsetsignale oder thermische oder zeitliche Driftsignale des optoelektronischen Empfängerbauteils oder gegebenenfalls des verstärkers/Filters, überlagert werden. Zur Elimination solcher Fremdsignale werden bei der digitalen Datenübertragung zur optischen Kodierung von Datenbits meist Lichtimpulse anstelle von statischen Lichtpegeln eingesetzt. Dies hat den Vorteil, dass der mittlere Strombedarf des Senders, insbesondere eines Leuchtmittels des Senders, minimiert wird. Beispielsweise wird eine zu übertragende "0" als Lichtimpuls, eine zu übertragende "1" dagegen als das Fehlen eines Lichtimpulses kodiert. Die Datenübertragung erfolgt dabei meist mit einer festen Übertragung- oder Taktrate (Baudrate).

Insbesondere bei mobiler. Datensystemen, beispielsweise bei Mobiltelefonen (Hanciys), personal digital assistents (PDAs) oder Nctebooks, in Verbindung mit einem zu dem mobilen Datensystem häufig stationären Gegenstück, wie bei-, spielsweise einem Personal Computer (PC), werden derzeit binäre Daten mit Infrarot-Lichtimpulsen nach dem bekannten quasigenormten IrDA (Infrared Data Association)-Protokoll kodiert und organisiert. Gemäß diesem Protokoll werden die Daten in Form von verhältnismäßig kurz andauernden Lichtimpulse übertragen.

Alternativ kann die Übertragung von binären optischen Daten nach dem bekannten ZVEI-Protokoll nach IEC 1107 organisiert sein. Dabei werden die Datenbits als impulsförmige Lichtpegel übertragen, deren Länge größer ist, als die Dauer der Lichtimpulse beim IrDA-Protokoll.

Empfangseinrichtungen bekannter Datenübertragungsvorrichtungen weisen oft Empfängerschaltungen auf, mit denen die analogen optoelektronischen Signale der häufig bereits in die Empfängerschaltungen integrierten optoelektronischen Empfängerbauelemente verstärkt, gefiltert und mit vorgegebenen Schwellwerten verglichen werden. Ein hierbei erzeugtes digitales Ausgangssignal kann einfach digital weiterverarbeitet werden. Zum Filtern werden insbesondere Hochpassfilter eingesetzt, mit denen langsam veränderliche Störeinflüsse abgetrennt werden. Häufig ist auch der Sender, beispielsweise eine integrierte Infrarot-LED, der einen eingebauten Impulsformer aufweisen kann, wobei die Empfängerschaltung in einen optoelektronischen Transceiverbaustein integriert ist.. Im Sender kann dann bekanntermaßen auch eine schaltbare Konstantstromquelle integriert sein. Durch paarweise Anordnung von solchen optoelektronischen Transceiverbausteinen ist derzeit eine komplette bidirektionale Übertragungsstrecke mit einer Reichweite, also einem Kommunikationsabstand zwischen den miteinander kommunizierenden Geräten beziehungsweise Datensystemen, im Bereich von bis 2 m realisierbar.

Damit dieser Kommunikationsabstand mit Transceiverbausteinen oder mit separaten Sende- und Empfangseinrichtungen erreichbar ist, muss der Schwellwert-Vergleich im Empfänger abhängig von der Signalstärke des empfangenen Lichtimpulses entsprechend empfindlich sein. Gleichzeitig muss jedoch verhindert werden, dass ein Störsignal, insbesondere ein Offset eines Vergleicher-Mittels der Empfangseinrichtung, insbesondere eines Komparators, fälschlicherweise als dem Datensignal zugehörig erfasst wird.

Auf dem Markt erhältliche Vergleicher-Mittel für bekannte Empfangaeinrichtungen, insbesondere in Transceiverbausteine enthaltene Empfangseinrichtungen, mit kleinen maximalen Offsets sind aufwändig herzustellen und auch teuer. Darüber hinaus lässt der Strombedarf bekannter Empfangseinrichtungen eine dauernden Empfangsbereitschaft batteriebetriebener Geräte mit langer Batterielebenwsdauer, wie beispielsweise bei Verbrauchsmessgeräten mit Batterielebensdauern von 5-15 Jahren, nicht zu.

Aufgabe der vorliegenden Erfindung ist, ein Verfahren und eine Vorrichtung der eingangs genannten Art so zu gestalten, dass technisch einfach auch mit insbesondere preiswerten Mitteln, insbescndere Vergleicher-Mitteln, die einen großen maximalen Offset aufweisen können, eine Vergrößerung der typischen Lichtempfindlichkeit der Empfangseinrichtung und damit eine Vergrößerung des Kommunikationsabstandes erreicht werden kann, wobei stets sicher gestellt sein soll, dass auch bei Vorliegen eines Störsignals, insbesondere eines Offsets nahe dem maximalen Offset des Vergleicher-Mittels, nie das Störsignal eine fälschliche Erfassung eines Datensignals bewirkt.

Diese Aufgabe wird erfindungsgemäß dadurch gelöst, dass das analoge Signal mit einem vorgegebenen analogen Schwellwert verglichen wird und ein binäres Ausgangssignal solange erzeugt wird, solange der vergleich ergibt, dass eine Amplitude des analogen Signals größer als der Schwellwert ist, wobei das analoge Signal und das Schwellwertsignal vertauscht werden, wenn das binäre Ausgangssignal länger erzeugt wird als eine vorgegebene maximale Dauer-ZUSTANDS-Zeit für das binäre Ausgangssignal.

Erfindungsgemäß wird also die Überschreitung der maximalen Dauer-ZUSTANDS-Zeit für das binäre Ausgangssignal als Indiz für das Vorliegen einer fälschlichen Erfassung eines Datensignals, insbesondere eines Dauersignals am Ausgang des Vergleicher-Mittels betrachtet, welches insbesondere durch einen positiven Offset des Vergleicher-Mittels hervorgerufen sein kann, der schon alleine oder gemeinsam mit etwaigen Störsignalen größer als der Schwellwert ist.

Das analoge Signal unterscheidet sich nämlich von dem Offset und/oder dem Störsignal dadurch, dass das analoge Signal eine begrenzte Dauer-ZUSTANDS-Zeit hat. Das heißt, das analoge Signal ist zwangsläufig stets nach den sich aus der übertragungsrate und dem Übertragungsprotokoll ergebenden Maximalzeiten logisch "AUS". Dem gegenüber können der Offset und/oder das Störsignal länger als die Dauer-ZUSTANDS-Zeit anliegen. Wenn also der Vergleich ein Ausgangssignal liefert, das länger andauert als die maximale Dauer-ZUSTANDS-Zeit, bedeutet dies, dass es nicht von dem analogen optoelektronischen Signal, sondern fehlerbedingt ist, insbesondere von zu starkem Offset herrührt.

Um der fälschlichen Datensignalerfassung entgegenzuwirken, wird eine analogelektrische Umpolung der Polarität des analogelektrischen Signals vorgenommen. Aus dem positiven Offset wird so ein negativer Offset, der dann kleiner ist als der Schwellwert. Das daueraktive Ausgangssignal verschwindet in Folge, und im Weiteren ist trotz des großen Offsets eine Datenerfassung mit großer Empfindlichkeit möglich, ohne dass es zu einer Dauerblockade der optischen Kommunikation kommt.

Es reicht also ein verhältnismäßig kleiner externer Schwellwert aus, um das Signal von einer Störung zu unterscheiden, so dass beispielsweise lediglich eine kleine Spannungsquelle zur Bereitstellung einer Schwellenspannung erforderlich ist. Damit ergibt sich bei dem am häufigsten vorkommenden Offset insbesondere von marktüblichen als Vergleicher-Mittel verwendeten Komparatoren nahe 0 mV eine sehr gute Empfindlichkeit.

Bei negativen Offsets verringert sich zwar die Empfindlichkeit durch den sich daraus ergebenden größeren relativen Schwellwert etwas, aber eine solche eher selten vorkommende geringere Empfindlichkeit und ein damit reduzierter Kommunikationsabstand eines gerade noch in der Spezifikation liegenden Ausreißerexemplars eines Vergleicher-Mittels ist insbesondere für die Anwendung bei einer mobilen optischen Datenablesung von Verbrauchszählernakzeptabel.

Auf diese Weise können auch mit technisch einfachen insbesondere preiswerten Vergleicher-Mitteln, die insbesondere große maximale offsets aufweisen, kleine Schwellwerte, also große typische Lichtempfindlichkeiten der Empfangseinrichtung, und damit große Korvmmikationsabstände erreicht werden, ohne dass Störsignale fälschlicherweise als Datensignal erfasst werden.

Die Erzeugung von analogen Datensignalen mit begrenzter Dauer-ZUSTANDS-Zeit erfordert darüber hinaus auf der Senderseite einen deutlich geringeren Energieaufwand als die Erzeugung von Dauersignalen, so dass beispielsweise bei batteriebetriebenen Geräten längere Standzeiten erzielbar sind.

Des Weiteren ist das Verfahren zur Elimination eines Offsets eines Vergleicher-Mittels auch bei Datenkodierungen mit stark dateninhaltsabhängigem Mittelwert, wie dies beispielsweise beim ZVEI-Protokoll der Fall ist, möglich.

Technisch einfach kann das analoge Signal mit einem analogelektrischen Komparator mit dem analogen Schwellwert verglichen werden und die Vertauschung von analogem optoelektronischen Signals und Referenzsignal kann mit einer steuerbaren Signalvertauschungseinrichtung erfolgen.

Zweckmäßigerweise kann die Datenübertragung mit Bit-und/oder Byte-orientierten Protokollen organisiert werden. Byte-orientierte Protokolle haben den Vorteil, dass mit ihnen Standardcodes, beispielsweise ASCII (American Standard Code for Information Interchange)-Codes, einfach übertragen werden können. Insbesondere bei bekannten Microcomputern und PCs sind solche Standardcodes weit verbreitet, so dass es einfach ist, beispielsweise reine ASCII-Texte zwischen verschiedenen Programmen oder Plattformen, also Betriebssystemen, auszutauschen.

Bit-orientierte Protokolle haben den Vorteil, dass die Übertragung nicht von einer Zeichenkodierung abhängig und nicht an Bytegrenzen gebunden ist. Des Weiteren sind für die Übertragung keine reservierten Zeichen erforderlich, da die Datenübertragung durch definierte Bitfolgen gesteuert wird.

Ferner können die begrenzte Dauer-ZUSTANDS-Zeit und die maximale Dauer-ZUSTANDS-Zeit von dem 3it- und/oder Byte-orientierten Protokoll vorgegeben werden, so dass keine separate Vorgabe der der maximalen Dauer-ZUSTANDS-Zeit erforderlich ist. Diese Zeiten können entsprechend dem verwendeten Protokoll standardisiert werden.

Ist der Offset zwar positiv aber kleiner als der Schwellwert, so erhöht sich zunächst nur die Empfindlichkeit. Kommt der positive Offset dagegen in die Nähe des Schwellwerts, so wird die Schaltung zwar noch nicht daueraktiv aber schon sehr empfindlich gegen optische und elektrische Störungen. Führen solche oder andere Störungen zu Bitfehlern, so kann dies spätestens auf einer Sicherungsschicht des Übertragungsprotokolls als Bitfehler oder als Timing-Fehler erkannt werden. In diesem Fall kann dann versuchsweise die Polarität des analogen optoelektronischen Signals ebenfalls in den jeweils anderen Zustand geändert und die Kommunikation wiederholt werden.

Zu diesem Zweck kann bei einer weiteren vorteilhaften Ausgestaltung des Verfahrens eine Überschreitung der maximalen Dauer-ZUSTANDS-Zeit mit einem retriggerbaren Monoflop und einem nachgeschalteten Flipflop erkannt werden. Dies hat den Vorteil, dass der einmal erreichte Umschaltzustand in dem Flipflop gespeichert werden kann. Die nächste Kommunkation wird mit dem einmal gelernten Umpolzustand gestartet, da sich das Vorzeichen des Cffsets, wenn überhaupt, später nur sehr langsam ändert. Dadurch wird es meist nur einmal, auf jeden Fall aber sehr selten, zu einem solchen Fehlversuch mit nachfolgender Wiederholung mit invertierter Empfangspolarität des Vergleicher-Mittels kommen.

Alternativ kann aus dem gleichen Grund die Überschreitung der maximalen Dauer-ZUSTANDS-Zeit und die Änderung der Polarität des analogen Signals insbesondere durch eine Digitalschaltung oder eine Software eines Mikrocontrollers oder Mikroprozessors, insbesondere eines dem Komparator nachgeschalteten oder mit dem Komparator und/oder der analogelektrischen Signalvertauschungseinrichtung integrierten Zeitüberwachungskreises oder eines Mikrocontrollers oder Mikroprozessors, realisiert werden. Bei Verwendung eines Mikrocontrollers oder Mikroprozessor kann darüber hinaus die Software individuell geändert und angepasst werden. Außerdem kann sie in einen ohnehin vorhandenen Mikrocontroller integriert werden, so dass kein separates Bauteil, beispielsweise ein Flipflop, erforderlich ist.

Zur Änderung der Polarität des analogen Signals kann das binäre Ausgangssignal insbesondere mit der Digitalschaltung oder der Software des Mikrocontrollers oder Mikroprozessors invertiert werden und mit dem invertierten Ausgangssignal die Änderung der Polarität des analogen Signals realisiert werden, indem die analogelektrische Signalvertauschungseinrichtung entsprechend angesteuert wird.

Die geänderte Polarität des analogen Signals kann bis zu einer weiteren Überschreitung der maximalen Dauer-ZUSTANDS-Zeit oder bis zur Erkennung eines Fehlers bei der Datenübertragung, insbesondere eines Fehlers im Bitbeziehungsweise Byte-orientierten Protokoll, oder bis zur Erkennung eines Timingfehlers oder bis zu einer Kommunikationspause beibehalten werden. Auf diese Weise wird die Umpolung zeitsparend nur einmal vorgenommen, wenn die Überschreitung der maximalen Dauer-ZUSTANDS-Zeit lediglich von einem großen Offset des Vergleicher-Mittels, insbesondere des Komparator, herrührt, da dieser Offset in der Regel dauerhaft ist.

Ferner kann die Änderung der Polarität des analogen Signals mit einem entsprechenden Wechsel eines Logikpegels des digitalen Signals gekoppelt werden.

Bei einer besonders einfachen Ausgestaltung des Verfahrens, mit der ein besonders großer Kommunikationsabstand zwischen dem Sender und dem Empfänger ermöglicht wird, kann für den analogen Schwellwert ein Wert vorgegeben werden, der kleiner ist als ein maximaler Offset insbesondere eines Vergleicher-Bauteils, mit dem das analoge Signal mit dem Schwellwert verglichen wird.

Um den Einfluß von Störsignalen zu verringern und einen deutlich größeren Kommunikationsabstand zu ermöglichen, können gegebenenfalls enthaltene konstante oder langsam veränderliche Störanteile aus dem analogen Signal insbesondere mit einem geeigneten analogelektrischen Filter, insbesondere einem Hochpassfilter, vorzugsweise einem CR-Glied, zumindest weitgehend eliminiert werden, bevor das analoge Signal mit dem analogen Schwellwert verglichen wird beziehungsweise bevor seine Polarität geändert wird. Alternativ kann zur Verringerung des Einflusses von Störsignalen das analoge Signal mit der Summe des Schwellwertes und dem geglätteten analogen Signal verglichen werden, insbesondere eine analoge Signalspannung auf einen der beiden Eingänge der Signalvertauschungseinrichtung mit dem nachgeschalteten Komparator und auf den anderen Eingang der signalvertauschungseinrichtung die durch einen Tiefpass, insbesondere ein RC-Glied, geglättete analoge Signalspannung zuzüglich einer analogen SchwellenSpannung gegeben werden.

Bei einer anderen alternativen Ausgestaltung des Verfahrens, bei dem ein Empfängerbauteil, insbesondere eine Fotodiode, ein Fototransistor, ein Fotowiderstand oder eine Fotozelle, im Generatormodus betrieben wird, kann zur Verringerung des Einflusses von Störsignalen der Schwellwert als geglätteter Bruchteil der Amplitude des analogen Signals bestimmt werden und mit dem nicht geglätteten analogen Signal verglichen werden, insbesondere ein Spannungsbruchteil der analogen Signalspannung auf einen der beiden Eingänge der Signalvertauschungseinrichtung mit dem nachgeschalteten Komparator und auf den anderen Eingang der Signalvertauschungseinrichtung die insbesondere mit einem Tiefpass geglättete analoge Signalspannung gegeben werden.

Um den Energieverbrauch deutlich zu verringern und so die Standzeiten von batteriebetriebenen Geräten deutlich zu verlängern, können die Daten, insbesondere die Datenbits, der optischen Datenübertragung durch Lichtimpulse mit einer mittleren Hellzeit von weniger als 25% einer Bitzeit kodiert werden.

Bei einer weiteren vorteilhaften Ausgestaltung des Verfahrens können die Daten, insbesondere die Datenbits, entsprechend der Quasinorm mit der Bezeichnung "IrDA" impulskodiert werden. Auf diese Weise können zur Datenübertragung weit verbreitete, dieser Quasinorm entsprechende, Infrarot-Schnittstellen verwendet werden.

Alternativ können die Daten, insbesondere Datenbytes, entsprechend der ZVEI-Norm (IEC 1107) kodiert werden, um einen Einsatz in Verbindung mit Schnittstellen, die dieser Norm entsprechen, zu ermöglichen.

Die Daten können zwischen mindestens einem mobilen Gerät und einem ortsfesten oder zwischen zwei mobilen Geräten übertragen werden. Aufgrund des großen kommunikationsabstandes, der mit der erfindungsgemäßen Datenübertragung erreicht werden kann, kann der Abstand zwischen den mobilen Geräten innerhalb großer Grenzen frei variiert werden.

Bei einer besonders vorteilhaften Ausgestaltung des Verfahrens können die Daten von und/oder zu einem insbesondere ortsfesten Verbrauchszähler, insbesondere einem Heizkosten-Verteiler oder einem Strom-, Gas-, Wasser-oder Wärmemengenzähler, übertragen werden. Auf Grund des geringen Energiebedarfs des erfindungsgemäßen Datenübertragungsverfahrens kann dann sowohl der ortsfeste verbrauchszähler, bei dem lange Standzeiten gefordert sind, als auch insbesondere ein mobiles Gegengerät batteriebetrieben werden.

Die erfindungsgemäße Vorrichtung zeichnet sich dadurch aus, dass der Umwandler ein Vergleicher-Mittel zum Vergleichen des analogen Signals mit einem vorgegebenen analogen Schwellwert und zur Erzeugung eines binären Ausgangssignals wenn eine Amplitude des analogen Signals größer als der analoge Schwellwert ist, und eine steuerbare analogelektrische Signalvertauschungseinrichtung, mit der die Polarität des analogen Signals beim Erreichen einer vorgegebenen maximalen Dauer-ZUSTANDS-Zeit für das binäre Ausgangssignal änderbar ist, aufweist.

Auf diese Weise sind auch einfache und insbesondere preiswerte Vergleicher-Mittel einsetzbar, die einen großen maximalen Offset aufweisen können.

Darüber hinaus ist eine große Lichtempfindlichkeit realisierbar, so dass auch bei einem großen Kommunikationsabstand zwischen dem Sender und dem Empfänger eine zuverlässige Datenübertragung möglich ist.

Bei einer vorteilhaften und technisch einfachen Ausführungsform kann das Vergleicher-Mittel ein analogelektrischer Komparator sein und wenigstens ein Ausgang der signalvertauschungseinrichtung wenigstens einem Eingang des Komparators vorgeschaltet sein.

Um die Vorrichtung bei Geräten einsetzen zu können, die Übertragungsprotokolle nach weit verbreiteten Standards einsetzen, insbesondere bei bekannten Minicomputern und PCs, kann die Datenübertragung mit Bit- und/oder Byte-orientierten Protokollen organisiert sein.

Um die vorgegebenen Daten entsprechend dem verwendeten Protokoll standardisieren zu können, können die begrenzte Dauer-ZUSTANDS-Zeit und die maximale Dauer-ZUSTANDS-Zeit von dem Bit- und/oder Byte-orientierten Protokoll vorgegeben sein.

Bei einer weiteren besonders vorteilhaften Ausführungsform kann dem Umwandler, insbesondere dem Vergleicher-Mittel, ein retriggerbares Monoflop und ein Flipflop zur Erfassung einer Überschreitung der maximalen Dauer-ZUSTANDS-Zeit nachgeschaltet sein. Mit dem retriggerbaren Monoflop ist einfach die maximale Dauer-ZUSTANDS-Zeit vorgebbar und in dem Flipflop kann der einmal erreichte Umschaltzustand einfach gespeichert werden.

Alternativ kann bei einer weiteren besonders vorteilhaften Ausführungsform eine Digitalschaltung oder ein Mikrocontroller oder Mikroprozessor mit einer Software zur Erfassung der Überschreitung der maximalen Dauer-ZUSTANDS - Zeit und zur Änderung der Polarität des analogen optoelektronischen Signals, insbesondere eine dem Vergleicher-Mittel nachgeschaltete oder mit dem Vergleicher-Mittel und/oder der analogelektrischen Signalvertauschungseinrichtung integrierte Digitalschaltung oder ein Mikrocontroller oder Mikroprozessor, vorgesehen sein. Die Soft-, ware ist besonders einfach an das jeweilige Gerät, welches die Vorrichtung zur Datenübertragung aufweist, und/oder unterschiedliche Empfängerbauelement, insbesondere Fotoelemente, anpassbar. Darüber hinaus kann ein ohnehin in dem Gerät vorhandener Mikrocontroller oder Mikroprozessor lediglich durch entsprechende Programmierung verwendet werden, so dass keine zusätzlichen Bauteile erforderlich sind.

Zweckmäßigerweise kann die Digitalschaltung beziehungsweise die Software des Mikrocontrollers cder Mikroprozessors ein Mittel zum Invertieren des digitalen Ausgangssignals aufweisen und die analogelektrische Signalvertauschungseinrichtung mit der Digitalschaltung beziehungsweise dem Mikrocontroller oder Mikroprozessor zum Vertauschen von analogem Meßsignal und Referenzsignal steuerbar verbunden sein. Auf diese weise ist technisch einfach mit wenigen Bauteilen eine Signalvertauschung realisierbar.

Um eine einmal auf den Offset des verwendeten Vergleicher-Mittels eingestellte Polarität beibehalten zu können, kann vorteilhafterweise ein Speichermittel, insbesondere ein Mikrocontroller oder Mikroprozessor mit einer Software oder ein Flipflop, zum Halten der geänderten Polarität des analogen Signals bis zu einer weiteren Überschreitung der maximalen Dauer-ZUSTANDS-Zeit oder bis zur Erkennung eines Fehlers bei der Datenübertragung, insbesondere eines Fehlers im Bit- und/oder Byte-orientierten Protokoll, oder bis zur Erkennung eines Timingfehlers oder bis zu einer Kommunikationspause, vorgesehen sein.

Zweckmäßigerweise kann die vertauschung von analogem Meßsignal und Referenzsignal mit einem entsprechenden Wechsel des Logikpegels des digitalen Signals am Ausgang des Vergleicher-Mittels gekoppelt sein.

Der analoge Schwellwert kann kleiner sein als ein maximaler Offset des Vergleicher-Mittels, insbesondere des Komparators, insbesondere kann das analoge Signal an einem ersten Eingang des Vergleicher-Mittels und der analoge Schwellwert an einem zweiten Eingang des Vergleicher-Mittels anliegen. Auf diese Weise ist auch bei Offsets, die kleiner als der maximale Offset des Vergleicher-Mittels sind, mit der Signalumpolung ein durch den Offset hervorgerufener verfälschter Vergleich als solcher erkennbar.

Zur Realisierung einer hohen Empfindlichkeit des Empfängers und damit zur Vergrößerung des Kommunikationsabstandes kann dem Vergleicher-Mittel und/oder der analogelektrischen Signalvertauschungseinriclitung ein geeignetes analogelektrisches Filter, insbesondere ein Hochpassfilter, vorzugsweise ein RC-Glied, zum zumindest weitgehenden Eliminieren gegebenenfalls enthaltener konstanter oder langsam veränderlicher Störanteile aus dem analogen optoelektronischen Signal, vorgeschaltet sein.

Alternativ können zur Vergrößerung der Empfindlichkeit des Empfängers und damit zur Vergrößerung des Kommunikationsabstandes dem Vergleicher-Mittel und/oder der analogelektrische Signalvertauschungseinrichtung ein Mittel zur Glättung des analogen Signals, insbesondere ein Tiefpass, vorzugsweise ein RC-Glied, und ein Mittel zum Addieren des Schwellwertes und des am Ausgang des Tiefpasses anliegenden gemittelten analogen Signals vorgeschaltet sein, insbesondere kann das analoge Signal gleichzeitig an einem der beiden Eingänge der Signalvertauschungseinrichtung mit dem nachgeschalteten Vergleicher-Mittel und am Eingang des Tiefpasses anliegen, wobei der Tiefpass und ein Mittel zur Erzeugung einer den analogelektrischen Schwellwert charakterisierenden Schwellenspannung dem anderen Eingang der Sisnalvertauschungseinrichtung in Reihe vorgeschaltet sein können-

Bei einer weiteren alternativen Ausführungsform, bei der ein Empfängerbauteil, insbesondere eine Fotodiode, ein Fototransistor, ein Fotowiderstand oder eine Fotozelle, im Generatormodus betreibbar ist, kann zur vergrößerung der Empfindlichkeit des Empfängers und damit zur Vergrößerung des Kommunikationsabstandes einem ersten Eingang des Vergleicher-Mittels und/oder der analogelektrischen Signalvertauschungseinrichtung ein Mittel zur Bildung eines Amplitudenbruchteils des analogen Signals, insbesondere ein Spannungsteiler, vorgeschaltet sein und einem zweiten Eingang des Vergleicher-Mittels und/oder der analogelektrischen Signalvertauschungseinrichtung ein Mittel zur Glättung des analogen Signals, insbesondere ein Tiefpass, vorgeschaltet sein.

Die Daten der Datenübertragung können kodierte Impulse mit einer mittleren EIN-Zeit von weniger als 25% einer Bitzeit sein, welche mit einem geringen Energieaufwand realisierbar sind. Dies ist insbesondere bei einer optischen Datenübertragung vorteilhaft.

im die vorrichtung bei weit verbreiteten Infrarot-Schnittstellen verwenden zu können, können die Daten, insbesondere die Datenbits, entsprechend der Quasinorm mit der Bezeichnung "IrDA" impulskodiert sind.

Alternativ können die Daten, insbesondere Datenbytes, entsprechend der ZVEI-Norm (IEC 1107) kodiert sein, so dass die Vorrichtung auch bei Schnittstellen, die diese Norm verwenden, einsetzbar ist.

Bei einer weiteren vorteilhaften Ausführungsform kann die Vorrichtung mit einem mobilen Gerät oder einem ortsfesten Gerät funktionell verbunden oder in dieses integriert sein. Insbesondere bei mobilen Geräten hat dies den großen Vorteil, dass wegen des großen kommunikationsabstandes, welchen die Vorrichtung ermöglicht, das mobile Gerät flexibel auch in einem großen Abstand von dem Kommunikationsgegengerät plaziert sein kann und dennoch eine problemlose und fehlerfreie Datenübertragung ermöglicht wird. Bei batteriebetriebenen Geräten, die mobil oder ortsfest sein können, ermöglicht der geringe Energiebedarf der Vorrichtung auch bei einer dauernden Empfangsbereitschaft lange Standzeiten der Geräte.

Bei einer weiteren besonders vorteilhaften Ausfuhrungsform kann die Vorrichtung insbesondere mit einem ortsfesten Verbrauchszähler, insbesondere einem Heizkosten-Verteiler oder einem Strom-, Gas-, Wasser- oder Wärmemengenzähler, funktionell verbunden oder in diesen integriert sein. Gerade dort ist die durch den geringen Energiebedarf der Vorrichtung ermöglichte lange Standzeit der Geräte von enormem Vorteil, da diese Geräte bei einer dauernden Empfangsbereitschaft oft zwischen 5 und 15 Jahre möglichst wartungsfrei in Betrieb sein sollen.

Ausführungsbeispiele der Erfindung werden nachfolgend anhand der Zeichnung näher erläutert. In dieser zeigen:
- Figur 1: schematisch ein Schaltbild einer aus dem Stand der Technik bekannten Empfängerschaltung einer Vorrichtung zur Datenübertragung mit einer Fotodiode zum Empfangen eines optischen Datensignals;
- Figur 2: schematisch ein Amplituden-Zeit-Diagramm eines nach dem IrDA-Übertragungsprotokoll kodierten binären Datensignals;
- Figur 3: schematisch ein Amplituden-Zeit-Diagramm eines alternativen nach dem ZVEI-Übertragungsprotokoll kodierten binären Signals;
- Figur 4: schematisch ein Schaltbild eines dem in Figur 1 gezeigten ähnlichen Komparators zum Vergleichen einer analogen Signalspannung mit einer vorgege-ben Schwellenspannung, wobei die Schwellenapannung größer als ein Offset des Komparators ist;
- Figur 5: schematisch einen Teil eines ersten Ausführungsbeispiels einer Empfängerschaltung einer erfindungsgemäßen Vorrichtung zur Datenübertragung;
- Figur 6: schematisch einen Teil eines zweiten Ausführungsbeispiels einer der in Figur 5 dargestellten ähnlichen Empfängerschaltung;
- Figur 7: schematisch einen Teil eines dritten Ausführungsbeispiels einer Empfängerschaltung;
- Figur 8: schematisch einen Teil eines vierten Ausführungsbeispiels einer Empfängerschaltung; und
- Figur 9: schematisch einen Teil eines fünften Ausführungsbeispiels einer Empfängerschaltung.

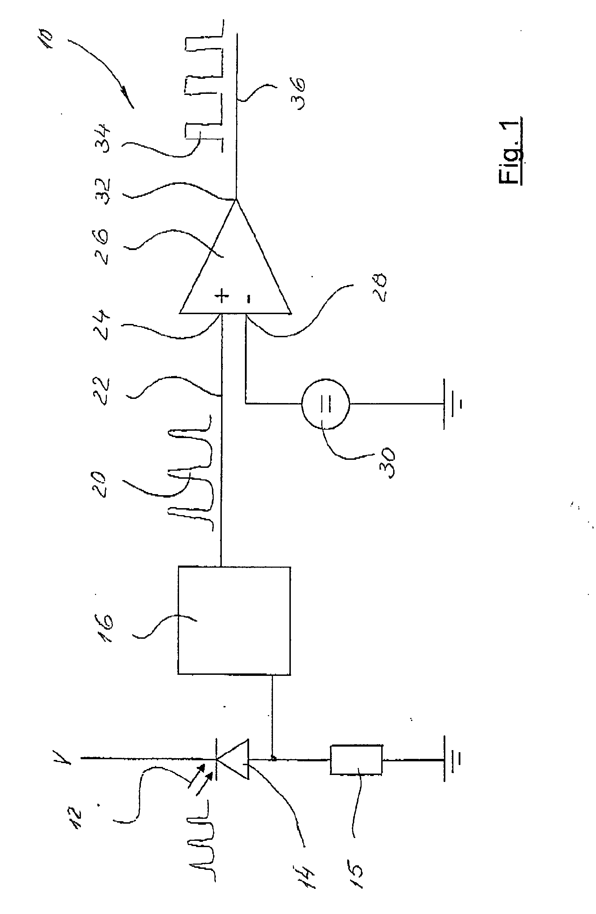

In Figur 1 ist eine insgesamt mit dem Bezugszeichen 10 bezeichnete aus dem Stand der Technik bekannte Empfängerschaltung einer Vorrichtung zur Datenübertragung dargestellt, die mit analogen optoelektronisch erhaltenen Signalen arbeitet.

Beim betrachteten Ausführungsbeispiel ist die ZUSTANDS-Zeit die EIN-Zeit des Signale, also die Zeit, in der das Signal den Pegel "1" hat.

Die Vorrichtung ist mit einem nicht dargestellten bekannten Verbrauchsmessgerät, beispielsweise einem Heizkosten-Verteiler, Wasser-, Wärme- Gas- und Stromzähler, verbunden. Sie dient zur Kommunikation mit einem anderen bekannten insbesondere auch mobilen, nicht dargestellten Gegengerät, von dem aus infrarote Lichtsignale 12 in Form von Lichtimpulsen, welche die zu übertragenden Daten charakterisieren, gesendet werden. Das Gegengerät weist hierzu einen entsprechenden Sender mit Halbleiter-LED's (Light Emitting Diode) zur Erzeugung der Lichtsignal auf.

Die Empfängerschaltung 10 weist in Figur 1 links eine Fotodiode 14 auf, mit der die infraroten Lichtsignale 12 in das analoge optoelektronische Signal ungesetzt werden. Die Fotodiode 14 ist mit ihrer einen Klemme auf Versorgungspotential V gelegt und mit ihrem anderen Anschluss über einen Widerstand 15 mit Masse verbunden. Der dazwischen liegende Knoten ist mit einem Eingang eines Filters /Verstärkers 16 verbunden, dem das analoge optoelektronische Signal zugeführt wird.

Anstelle der Fotodiode 14 kann die Empfängerschaltung 10 auch ein andersartiges optoelektronisches Empfängerbauelement, insbesondere einen Fototransistor, einen Fotowiderstand oder eine Fotozelle aufweise, und das mit diesem erzeugte analoge optoelektronische Signal kann einem an das andersartige optoelektronische Empfängerbauelement angepassten und entsprechend geschalteten Filter/Verstärker 16 zugeführt werden. Es können auf diese Weise analoge optoelektronische Signale in Form von Spannungs-, Strom- oder Widerstandssignalen an den Filter/Verstärker 16 übermittelt werden.

Mit einem analogelektrischen Filter des Filters / Verstärkers 16 werden etwaige.konstante oder zeitlich langsam veränderliche Störsignalanteile, die insbesondere von optischen oder elektrischen Störungen herrühren können, von dem analogen optoelektronischen Signal abgetrennt beziehungsweise das analoge optoelektronische Signal geglättet.

Außerdem wird das analoge optoelektronische Signal mit einem nicht dargestellten Verstärker verstärkt und an einem Ausgang des Filters/Verstärkers 16 als analoge Signalspannung 20 (photoelektrisches Nutzsignal) bereitgestellt.

Von dem Ausgang des Filters/Verstärkers 16 führt eine Signalleitung 22 zu einem ersten Eingang 24 eines analogen Komparators 26, der als Vergleicher-Mittel wirkt, an dem somit die analoge Signalspannung 20 anliegt.

Ein zweiter Eingang 28 des Komparators 26 ist mit einem Spannungsteiler einer Geräte-Versorgungsspannung des Verbrauchsmessgerätes verbunden, der einen Schwellwertgenerator 30 bildet. An dem Spannungsteiler wird eine vorgegebene Schwellenspannung abgegriffen und an den zweiten Eingang 28 des Komparators 26 angelegt.

Mit dem Komparator 26 wird die analoge Signalspannung 20 mit der Schwellenspannung verglichen. Ist die analoge Signalspannung 20 kleiner als die Schwellenspannung (dies ist der Fall wenn die Fotodiode 14 keinen Lichtimpuls empfängt) so wird an einem Ausgang 32 des Komparators 26 ein binäres Signal 34 in Form einer logischen "0" als binäres Aussignal bereitgestellt. Ist hingegen die analoge Signalspannung 20 größer als die Schwellenspannung so wird am Ausgang 32 des Komparators 26 eine logische "1" als binäres Ausgangssignal ausgegeben. Auf diese Weise wird mit dem Komparator 26 das analoge optoelektronische Signals in Form der analogen Signalspannung 20 in das binäre Signal 34 umgewandelt. Das binäre Signal 34 wird dann über eine Binär-Signalleitung 36 einem Mikroprozessor des Verbrauchsmessgerätes zugeführt, wo es digital weiterverarbeitet wird.

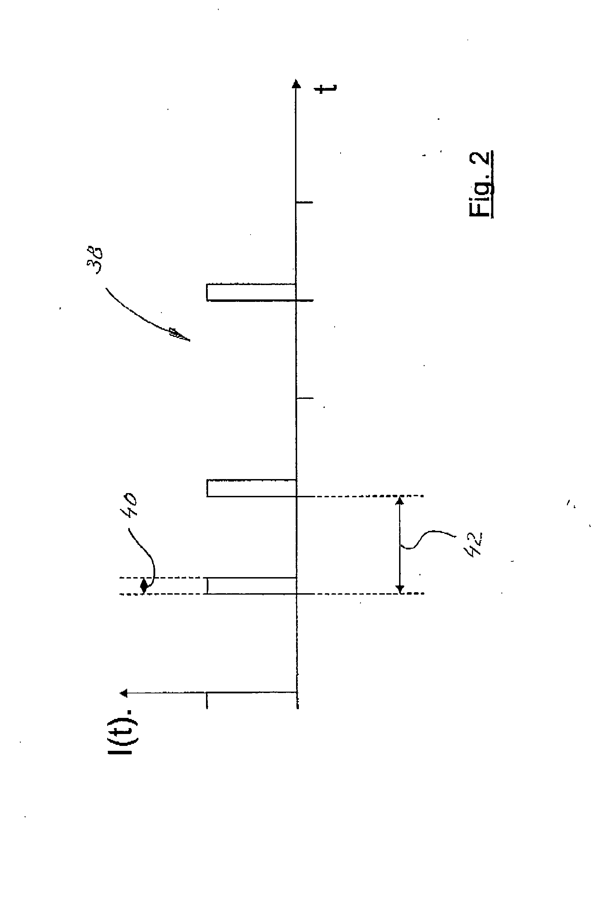

In Figur 2 ist ein Amplituden-Zeit-Diagramm eines nach dem quasigenormten IrDA-Übertragungsprotokoll kodierten binären Datensignals 38, welches mit der Empfängerschaltung 10 aus Figur 1 aus einer entsprechend kodierten impulsförmigen analogen Signalspannung umgewandelt werden kann, dargestellt. Die Amplitude des Datensignals 38 ist nach oben, der Zeitverlauf nach rechts aufgetragen. Eine zu übertragende "0" ist als Lichtimpuls, eine zu übertragende "1" dagegen als das Fehlen eines Lichtimpulses des ursprünglichen, aus dem in Figur 1 dargestellten ähnlichen Lichtsignale kodiert.

Unter der EIN-Zeit wird die Zeitdauer des transienten Zustandes verstanden.

Bei dem IrDA-Übertragungsprotokoll werden die Daten bei einer vereinbarten Übertragmgsrate (Baudrate) übertragen, welche vorzugsweise mindestens 9600 Baud beträgt. Die Übertragungsrate kann statt dessen nach einer einer Verbindungsaufnahme folgenden protokolltechnischen Vereinbarung der kommunizierenden Geräte auch Zweierpotenzen von 9600 Baud betragen.

Bei dem in Figur 2 dargestellten Datensignal 38 beträgt die Dauer 40 der Lichtimpulse maximal 3/16 einer Periode (Bitzeit) 42, mindestens aber 1,84 *µs*. Die Bitzeit 42 ist mindestens gleich der Zeit, welche für den Empfang und die Speicherung eines Bits benötigt wird.

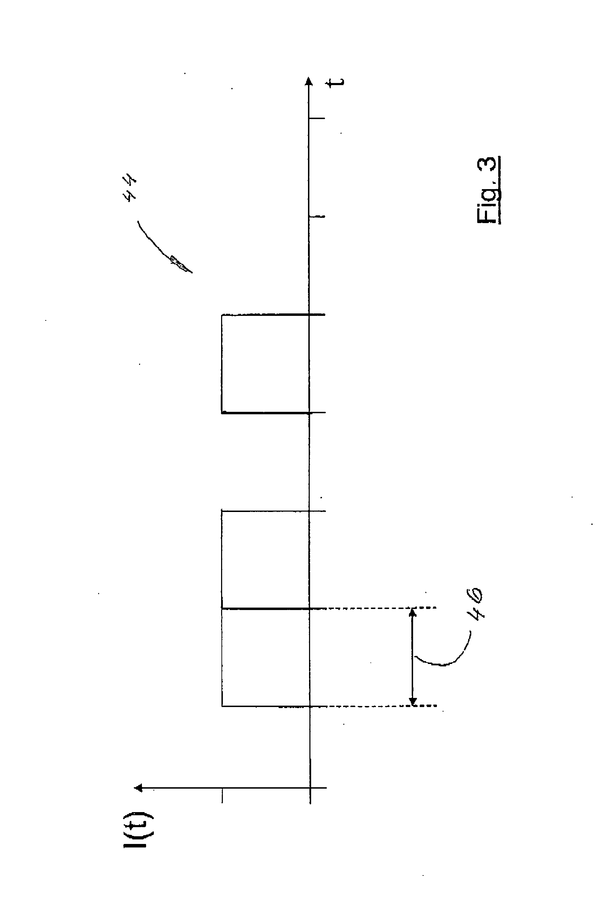

In Figur 3 ist schematisch ein in der Zuweisung der Achsen dem in Figur 2 dargestellten entsprechendes Amplituden-Zeit-Diagramm eines alternativ nach dem ZVEI-Übertragungsprotokoll nach IEC 1107 kodierten binären Datensignals 44, welches mit der Empfängerschaltung 10 aus Figur 1 aus einer entsprechend kodierte impulsförmigen analogen Signalspannung umgewandelt werden kann, dargestellt. Dabei werden die Datenbits als Pegel, deren Dauer einer Periode (Bitzeit) 46 entspricht, übertragen, wobei "0" dem Zustand "Licht an" und "1" dem Zustand "Licht" aus" entspricht. Hierbei wird ein einfaches asynchrones Protokoll eines universellen asynchronen Empfangs- und Sendebausteins (UART-Protokoll) als Byte-orientiertes Protokoll eingesetzt, bei dem fünf bis acht Datenbits (Nutzbits) eines Bytes von einem Startbit, welches stets gleich "0" ist, und einem Stoppbit, welches stets gleich "1" ist, eingerahmt sind. Auch hier kommt im zeitlichen Abstand von maximale elf Bitzeiten 46 durch das Stoppbit mindestens ein "1"-Signal, welches dem Zustand "Licht aus" entspricht, vor.

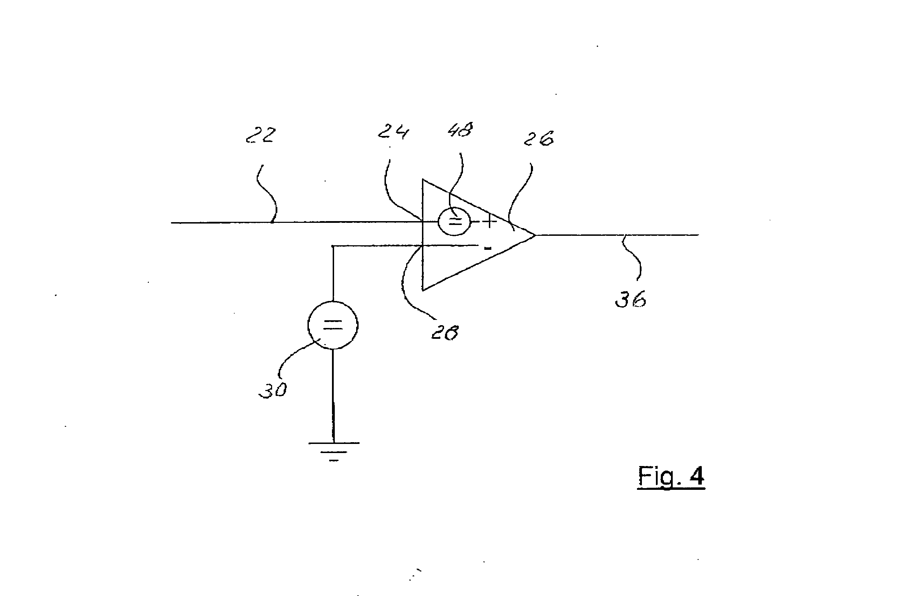

In Figur 4 ist schematisch ein Teilschaltbild einer dem in Figur 1 gezeigten ähnlichen Empfängerschaltungs 10 mit einem Komparator 26 zum Vergleichen der analogen Signalspannung 20 mit einer vorgegeben Schwellenspannung des Schwellwertgenerators 30 im Detail gezeigt. Diejenigen Elemente, die zu denen der oben in Verbindung mit Figur 1 beschriebenen Empfängerschaltung 10 ähnlich sind, sind mit denselben Bezugszeichen versehen, so dass bezüglich deren Beschreibung auf die Ausführungen dort Bezug genommen wird. Die Schwellenspannung des Schwellwertgenerators 30 ist bei dem in Figur 4 dargestellten Komparator 26 größer als ein als interne Spannungsquelle 48 veranschaulichter Komparator-Offset vorgegeben.

Die Schwellenspannung des Schwellwertgenerators 30 ist hier so vorgegeben, dass auch bei einem nach dem Datenblatt des Komparators 26 maximalen Komparator-Offset, welcher der Spannungs-Offset zuzüglich dem Produkt aus einem Strom-Offset und einem Quellwiderstand ist, ohne Lichtsignal kein Ausgangssignal am Ausgang 32 des Komparators 26 entsteht.

Solche Offsets können einerseits durch fertigungsbedingte systematische oder statistische Asymmetrien entstehen. Sie können sich durch Temperatureinflüsse, Änderung der Versorgungsspannung oder durch Alterung zeitlich langsam verändern und können daher nur teilweise durch einen Fertigungsabgleich kompensiert werden. Teure Präzisionskomparatoren erreichen hier gute, das heißt kleine, Offsetwerte; preiswerte Komparatoren sind hier deutlich schlechter. Besonders schlecht in dieser Hinsicht, aber auch besonders preiswert, sind in Mikrocontroller oder Mikroprozessoren integrierte analogelektrische Komparatoren. Durch den dort auf digitale Signale optimierten Halbleiterprozess und durch Störeinflüsse der digitalen Schaltung auf die empfindlichen Analogelemente lassen sich nur mäßige Offsetwerte erreichen.

Da das Vorzeichen des maximale Komparator-Offsets bei Komparatoren der gleichen Art unterschiedlich sein kann und daher für den jeweils verwendeten Komparator 26 nicht von vornherein bekannt ist, muss die Schwellenspannung des Schwellwertgenerators 30 mindestens so groß vorgegeben werden, wie der Betrag des beispielsweise im Dater.-blatt des Komparators 26 angegebenen maximalen Komparator-Offsets, damit bei einem positiven Komparator-Offset nicht auch schon ohne Lichtimpuls, also ohne analoge Signalspannung 20, ein Signal am Ausgang 32 des Komparators 26 ausgegeben wird.

Damit der Komparator 26 den Lichtimpuls auch bei einem negativen maximalen Komparator-Offset erkennt, muss die garantierbare Mindest-Amplitude der analogen Signalspannung 20 das Doppelte des Betrages des maximalen Komparator-Offsets sein. Ist der komparator-Offset viel kleiner als der im Datenblatt des Komparators 26 garantierte maximale Komparator-Offset, was typischerweise bei realen Komparatoren der Fall ist, entspricht die typische Empfindlichkeit des Komparators 26 für die Erkennung einer analogen Signalspannung 20 als Lichtimpuls der vorgegebenen Schwellenspannung des Schwellwertgenerators 30.

Beträgt der maximale Komparator-Offset beispielsweise ±50 mV, so wird eine Schwellenspannung des Schwellwertgenerators 30 von vorzugsweise 60 mV vorgegeben, damit auch bei dem maximalen positiven Komparator-Offset von +50 mV noch eine optische Mindest-Amplitude der analogen Signalspannung 20 von 10 mV gewährleistet ist, wie sie erforderlich' ist um die analoge Signalspannung 20 von kleinen Störspannungen, die von optischen und/oder elektrischen Störungen herrühren, unterscheiden zu können.

Die typische Schwellenspannung des Schwellwertgenerators 30, das heißt die typische Empfindlichkeit, wird dann bei dem Komparator-Offset nahe 0 mV, welcher am häufigsten auftritt, 60 mV betragen. Die geringste Empfindlichkeit ergibt sich entsprechend bei einem maximalen negativen Komparator-Offset von -50 mV zu dann insgesamt 110 mV. Damit ist die Empfängerschaltung 10 relativ unempfindlich. Bei einer kleineren Schwellenspannung des Schwellwert generators 30, welche eine entsprechend höhere Empfindlichkeit zur Folge hat, besteht dagegen stets die Gefahr, dass es bei einem großen positiven Komparator-Offset auch schon ohne Lichtimpulse zu einem dauerhaften Signal am Ausgang 32 des Komparators 26 kommt, und damit unabhängig von der Signalamplitude zu einem dauerhaften völligen Versagen der gesamten optischen Kommunikation.

Eine Verbesserung der Empfindlichkeit auch bei großen maximalen Komparator-Offsets lehrt hier die Erfindung, die im folgerden näher erläutert wird:

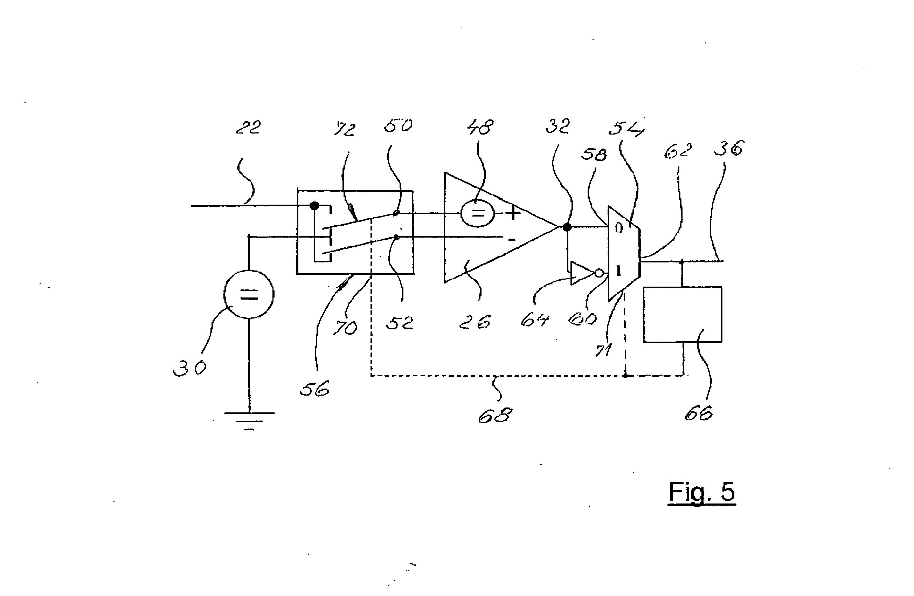

In Figur 5 ist schematisch ein Teilschaltbild eines ersten Ausführungsbeispiels einer Empfängerschaltung 10 einer erfindungsgemäßen Vorrichtung zur Datenübertragung mit der aus einem optischen Signal erzeugten analogen optoelektronischen Signalspannung 20 dargestellt.

Die Empfängerschaltung 10 umfasst einen dem in Figur 1 dargestellten ähnlichen Komparator 26. Ausgänge 50 und 52 einer Signalvertauschungseinrichtung 56 sind den Eingängen 24 beziehungsweise 28 des Komparators 26 vorgeschaltet. Mit der Signalvertauschungseinrichtung 56 ist die Polarität der analogen Eingangsspannung des Komparators 26 veränderbar.

Ein Digital-Umschalter 54 weist zwei Eingänge 58 und 60, und einen Signalausgang 62 auf. Der erste Eingang 58 des Digital-Umschalters 54 ist direkt mit dem Ausgang 32 des Komparators 26 verbunden. Dem zweite Eingang 60 ist ein NOT-Gatter 64 vorgeschaltet, dessen Eingang mit dem Ausgang 32 des Komparators 26 verbunden ist.

An die Leitung 36 ist ein zeitüberwachungskreis 66 angeschlossen, der die Polarität seines Ausgangssignales immrer dann wechselt, wenn über eine vorgegebene, verglichen mit der Länge eines Datenwortes lange Zeit kein Signalwechsel auf der Binär-Signalleitung 36 beobachtet wird.

Der Ausgang des Zeitüberwachungskreises 66 ist über eine Steuerleitung 68 mit einem Steuereingang 70 der Signalvertauschungseinrichtung 56 und einem Steuereingang 71 des Digital-Umschalters 54 verbunden. Der Zeitüberwachungskreis 66 arbeitet genauer gesagt so, daß er dann sein Ausgangssignal ändert, wenn über die maximale Dauer-ZUSTANDS-Zeit (beim Ausführungsbeispiel maximale Dauer-EIN-Zeit) kein Signal erhalten wurde.

Der Signalausgang 62 fu̅hrt über die Binär-Signalleitung 36 zu eine m nicht dargestellten Mikroprozessor des Verbrauchsmessgerätes. Am Signalausgang 52 liegt, wie am Ausgang 32 des Komparators 26, das umgewandelte binäre, ggf. invertierte, Signal 34 an.

Da der Digital-Umschalter 54 immer zusammen mit der Signalumpoleinrichtung 56 umgesteuert wird, hat man die selbe Polarität des Ausgangssignales unabhängig davon, ob man den positiven oder den negativen Ast der Kennlinie des Komparators 26 nutzt.

Mit dem Ausgangssignal des Zeitüberwachungskreises 66 ist somit der Steuereingang 70 der Signalvertauschungseinrichtung 56 beaufschlagbar, und so ist eine Umschaltung der Polarität der analogen Signalspannung 20 steuerbar.

Die Signalvertauschungseinrichtung 56 weist einen analogelektrischen Umpolschalter 72, vorzugsweise einen CMOS-Analog-schalter, beispielsweise einen Baustein HC4052, auf.

Die Vorgabe der externen Schwellenspannung des Schwellengenerators 30 bestimmt sich hier durch eine im Vergleich zu dem Komparator 26, der in Figur 4 dargestellt ist, verhältnismäßig kleine Spannung, beispielsweise 10 mV, womit die analoge Signalspannung 20 von Störungen unterschieden werden kann. Damit ergibt sich bei dem am häufigsten auftretenden Komparator-Offset nahe 0 mV eine sehr gute Empfindlichkeit, bei den oben in Zusammenhang mit Figur 4 lediglich beispielhaft gewählten Offset-Werten von etwa 10 mV.

Bei negativen Komparator-Offsets verringert sich zwar die Empfindlichkeit durch den sich daraus ergebenden größeren relativen Schwellwert, der sich aus der Schwellenspannung und dem Komparatcr-Offset zusammensetzt, etwas. Mit den oben in Verbindung mit den Ausführungen zu Figur 4 eingeführten beispielhaften Werten ergäbe sich dann eine garantierte Mindestempfindlichkeit von 60 mV anstelle von 110 mV, wie dies bei der Empfängerschaltung 10 aus Figur 4 ohne Signalvertauschungseinrichtung 56 der Fall ist. Eine solche eher seltene geringere Empfindlichkeit, welche auch einen reduzierten Kommunikationsabstand zur Folge hat, eines gerade noch in der Spezifikation bezüglich des maximalen Komparator-Offsets liegenden Ausreißerexemplars eines Komparators 26 ist aber insbesondere für eine Anwendung einer mobilen optischen Datenablesung von Verbrauchszählern akzeptabel.

Hat nun aber der Komparator 26 einen positiven Komparator-Offset,insbesondere einen größeren als die hier verhältnismäßig kleine Schwellenspannung des Schwellwertenerators 30, so entsteht am Ausgang 32 des Komparators 26 ein Dauersignal. Da das optische Lichtsignal und damit die analoge signalspannung 20 durch sein Bit- und/oder Byte-orientiertes Protokoll aber stets nach den sich aus der Ünertragungsrate und dem Bit-orientierten Protokcll ergebenden Maximalzeiten logisch "Aus" sein muss beziehungsweise 0 V betragen muss, kann aus einem länger als diese Maximalzeit andauernd aktiven Ausgangssignals arr. Ausgang 32 des Komparators 26 geschlossen werden, dass ein zu großer positiver Komparator-Offset vorliegt, welcher das Vorliegen einer einen Lichtimpuls charakterisierenden analoge Signalspannung 20 vortäuscht.

Nun wird durch den Zeitüberwachungskreis 66 die Signalvertauschungseinrichtung 56 angesteuert und mit dieser die Polarität der analogen Signalspannung 20 an den Eingängen 24 und 28 des Komparators 26 gewechselt. Durch die damit geänderte logische Polarität und durch eine mit dem Umpolschalter 72 gekoppelte Digitalinversion des digitalen Ausgangssignales 32 des Komparators 26 sind nun die Arbeitsbedingungen so geändert, daß statz des positiven Komparator-Offsets der negative Komparator-Offset zum Tragen kommt. In Folge verschwindet das daueraktive Ausgangssignal am Ausgang 32 des Komparators 26 und es wird wieder eine normale Funktion und Empfindlichkeit des Komparators 26 erhalten.

Ist der Komparator-Offset zwar positiv aber kleiner als die Schwellenspannung 30, so erhöht sich zunächst nur die Empfindlichkeit. Ist der positive Komparator-Offset des verwendeten Komparators 26 dagegen etwa so groß wie die Schwellenspannung 30, so entsteht am Ausgang 32 des Komparators 26 noch kein daueraktives Ausgangssignal. Die Empfängerschaltung ist aber sehr empfindlich gegenüber optischen und elektrischen Störungen. Führt eine solche Störung zu Bitfehlern, so wird dies spätestens auf einer Protokoll-Sicherungsschicht als Bitfehler oder als Timing-Fehler erkannt. In diesem Fall wird dann versuchsweise der Umpolschalter 72 und der Umschalter 54 in die jeweils andere Stellung umgeschaltet und die Kommunikation wiederholt.

Der einmal zu einer erfolgreichen Signalumwandlung führende umschaltzustand des Umpolschalters 72 kann mit einem nicht dargestellten Flipflop gespeichert werden. Die nächste Kommunikation wird darn mit dem erlernten Umpolzustand gestartet, da sich das Vorzeichen des Komparator-Offsets, wenn überhaupt, später nur sehr langsam ändert. Dadurch wird es meist nur einmal, auf jeden Fall aber sehr selten, zu einem solchen Fehlversuch mit nachfolgender Wiederholung mit invertierter Empfangspolarität des Komparators 26 kommen.

Insgesamt ergibt sich also mit den oben eingeführten beispielhaften Zahlenwerten eine Verbesserung der typischen Empfindlichkeit für einen Komparator-Offset nahe 0 mV gegenüber einer Schaltung des Komparators 26 ohne signalumpolung, wie er in den Figur 4 dargestellt ist, um einen Faktor sechs, nämlich 10 mV statt 60 mV, und eine Verbesserung der garantieren Empfindlichkeit für einen maximalen Komparator-Offset von 50 mV etwa um einen Faktor zwei, nämlich 60 mV statt 110 mV. Trotzdem kommt es auch bei einem großen Komparator-Offset nie zu einer Dauerblockade der optischen Kommunikation für eine so hohe Empfindlichkeit, wie dies bei der Schaltung des Komparators 26 ohne Signalumpolung der Fall ist.

Eine ähnliche, nicht dargestellte Kombination eines preiswerten Komparators 26 mit einer integrierten Signalvertauschungseinrichtung 56 (Umpolender Komparator) ist beispielsweise bei bekannten Mikrocontrollern oder Mikroprozessoren, insbesondere bei einer Mikrocontroller-Baureihe mit der Bezeichnung MSP430 der Firma von Texas Instruments, implementiert.

Statt gesteuert durch den Zeitüberwachungskreis 66 kann der Umpolschalter 72 die Polarität der analogen Signalspannung 20 auch gesteuert durch eine Software, insbesondere eine Auswertesoftware, eines Mikroprozessors oder eines Mikrocontrollers wechseln.

Der einmal erreichte Umschaltzustand des Umpolschalters 72 kann statt mit dem nicht dargestellten Flipflop auch mit der Software des Mikroprozessors oder Mikrocontrollers gespeichert werden.

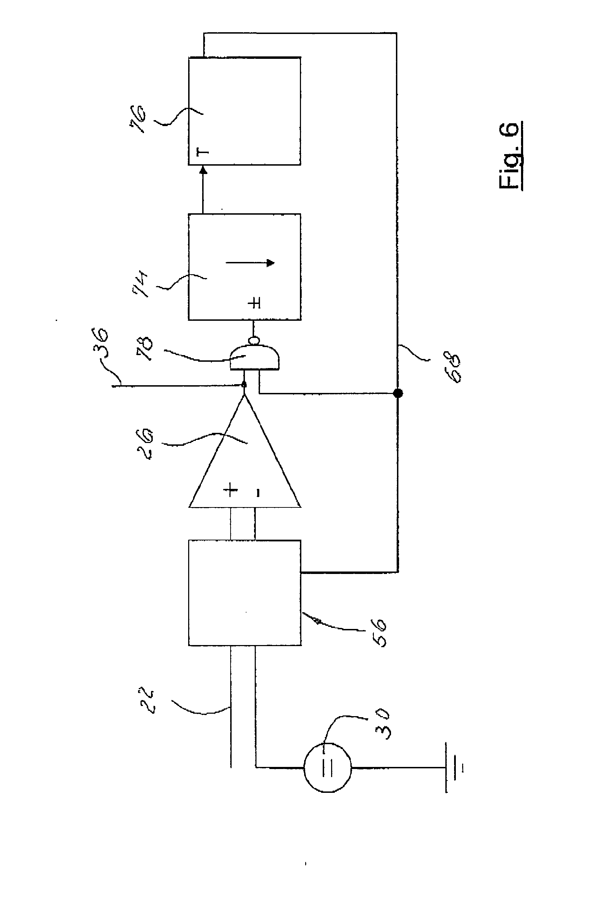

In Figur 6 ist schematisch ein Teilschaltbild eines zweiten Ausführungsbeispiels einer der Empfängerschaltung von Figur 5 ähnlichen, Empfängerschaltung 10 dargestellt. Bei dem zweiten Ausführungsbeispiel sind diejenigen Elemente, die zu denen des ersten, in Figur 5 beschriebenen Ausführungsbeispiels ähnlich sind, mit denselben Bezugszeichen versehen, so dass bezüglich deren Beschreibung auf die Ausführungen zum ersten Ausführungsbeispiel Bezug genommen wird.

Dieses Ausführungsbeispiel unterscheidet sich von dem ersten dadurch, dass eine signalvertauschungseinrichtung 56 statt über den zeitüberwachungskreise 66 über ein retriggerbares Monoflop 74 und ein Toggle-Flipflop 76 mit dem Ausgang 32 des Komparators 26 steuerbar verbunden ist.

Der Ausgang 32 des Komparators 26 ist hierbei mit einem ersten Eingang eines NAND-Gatters 78 verbunden. Der zweite Eingang des NAND-Gatters 78 ist gleichzeitig mit einem Ausgang des Toggle-Flipflops 76 und dem Steuereingang 70 der Signalvertauschungseinrichtung 56 verbunden. Vom Ausgang des NAND-Gatters 78 führt eine Leitung zum Eingang des Monoflop 74. Dessen Ausgang ist mit einem Eingang des Toggle-Flipflops 76 verbunden.

Ein Überschreiten der maximalen Dauer-ZUSTANDS-Zeit eines Ausgangssignals am Ausgang 32 des Komparators 26 wird mit dem retriggerbaren Monoflop 74 und dem Toggls-Flipflop 76 erfasst. Daraufhin wird die Signalvertauschungseinrichtung 56 über den Ausgang des Toggle-Flipflops 76 entsprechend angesteuert und die Polarität der analogen Signalspannung 20 sc geändert.

Insbesondere bei gepulsten Bit-orientierten Protokollen, wie beispielsweise beim IrDA-Brotokoll, lässt sich sowohl der konstante, als auch der zeitlich langsam variable Störsignalanteil der analogen Signalspannung 20 bei den folgenden, zu dem ersten und zweiten Ausführungsbeispielen ähnlichen Ausführungsbeispielen, eliminieren:

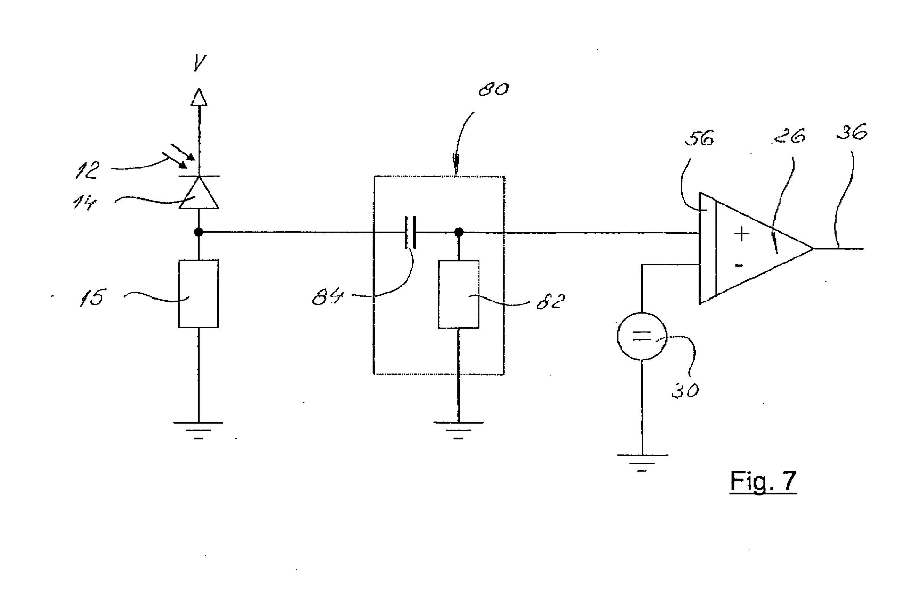

In Figur 7 ist schematisch ein Teilschaltbild eines dritten Ausführogsbeispiels einer Empfängerschaltung 10 einer Vorrichtung zur Datenübertragung mit einem analogen optoelektronischen Signal dargestellt. Diejenigen Elemente, die zu denen des ersten und des zweiten, in Figuren 5 beziehungsweise 6 dargestellten, Ausführungsbeispielen ähnlich sind, sind mit denselben Bezugszeichen versehen, so dass bezüglich deren Beschreibung auf die Ausführungen zum ersten beziehungsweise zweiten Ausführungsbeispiel Bezug genommen wird.

Die Empfängerschaltung 10 weist einen Hochpassfilter 80 zum Filtern der analogen Signalspannung 20 auf. Darüber hinaus weist er eine umpolende Komparator-Einheit 26 mit einer en Signalvertauschungseinrichtung 56 zum Umpolen der Polarität auf, die dem gleichen Zweck dient und genauso arbeitete wie die Signalvertauschungseinrichtung 56 nach den Ausführungsbeispielen von Figur 5 beziehungsweise Figur 6.

Eine Leitung zwischen der Fotodiode 14 und dem mit der Masse verbundenen Widerstand 15 ist mit einem ersten Anschluss eines Kondensators 84 des analogelektrischer Hochpassfilters 80 in Form eines RC-Glieds verbunden. Ein zweiter Anschluss des Kondensators 84 ist über einen zugleich als Ausgang des Hochpassfilters 80 dienenden Knoten sowohl mit einem ersten Anschluss eines Hochpass-Widerstandes 82 des Hochpassfilters 80 als auch mit einem ersten Eingang des umpolenden Komparators 26 verbunden. Die Zeitkonstante des Hochpassfilters 80 ist so vorgegeben, dass langsam veränderliche Störeinflüsse von der analogen Signalspannung 20 abgetrennt werden und diese so gefiltert wird.

Der erste Eingang des umpolenden Komparators 26 ist so mit der gefilterten analogen Signalspannung 20 beaufschlagt. Der andere Eingang des umpolenden Komparators 26 ist mit dem Ausgang des Schwellwertgenerators 30 verbunden und ist so mit der schwellenspannung beaufschlagt.

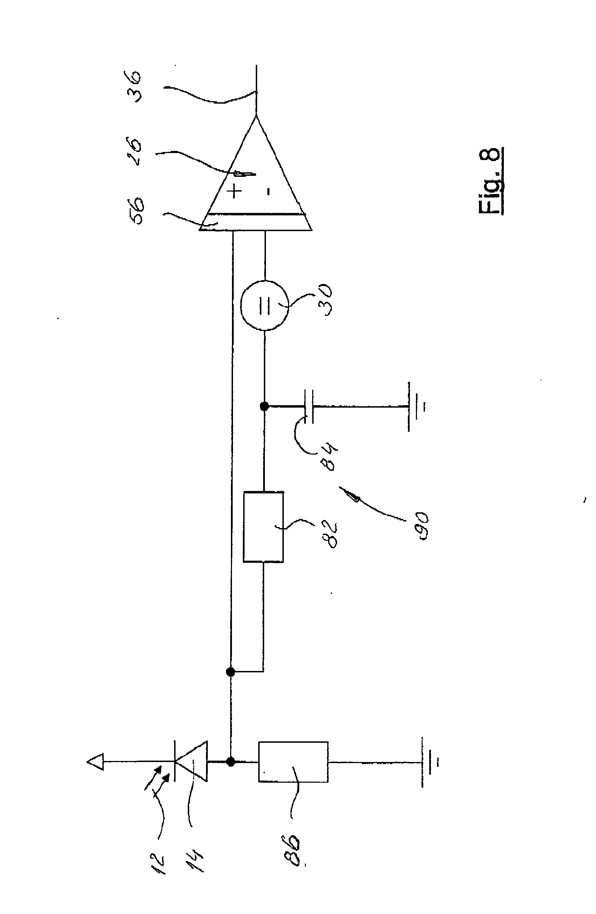

In Figur 8 ist schematisch ein Teilschaltbild eines vierten Ausführungabeispiels einer Empfängerschaltung 10 einer Vorrichtung zur Datenübertragung mit einem analogen ootoelektronischen Signal dargestellt. Diejenigen Elemente, die zu denen des dritten, in Figur 7 dargestellten, Auaführungsbeispiels ähnlich sind, sind mit denselben Bezugszeichen versehen, so dass bezüglich deren Beschreibung auf die Ausführungen zum dritten Ausführungsbeispiel Bezug genommen wird.

Bei der Empfängerschaltung 10 gemäß dem vierten Ausführungsbeispiel ist ein Tiefpass 90 mit dem Schwellwertenerator 30 in Reihe geschaltet dem zweiten Eingang des umpolenden Komparators 26 aus Figur 7 vorgeschaltet. Im Unterschied zum dritten, in Figur 7 beschriebenen Ausführungsbeispiel, ist die Leitung zwischen der Fotodiode 14 und dem mit Masse verbundenen Widerstand 15 über eine erste Verzweigung direkt mit dem ersten Eingang des umpolenden Komparators 26 verbunden.

Von einem Tiefpass-Widerstand 82 führt eine weitere Leitung zu einem ersten Anschluss eines Tiefpass-Kondensators 84. Der zweite Anschluss des Kondensators 94 liegt auf Masse. Der zwischen Tiefpass-Widerstand 82 und Tiefpass-Kondensator 84 liegende Knoten ist zugleich der Ausgang des Tiefpasses 90.

An dem Auslaß des Tiefpasses 90 hängt die eine Klemme des Schwellwertgenerators 30. Von dessen zweiter Klemme führt eine Leitung zum zweiten Eingang des umpolenden Komparators 26.

Auf diese Weise wird die am Ausgang des Tiefpasses 90 anliegende geglättete analoge Signalspannung 20 zu der Schwellenspannung 30 hinzuaddiert, so dass Largzeitdrifts der Signalspannung 20 mit kompensiert werden.

Beim Empfang eines binär kodierten optischen Signals wird die analoge Signalspannung 20, welche mit Gleichlichtbedingten Komponenten und Störkomponenten überlagert sein kann, direkt auf den ersten Eingang des umpolenden Komparators 26 gegeben. Gleichzeitig wird mit dem Tiefpass 90 der Mittelwert der analogen Signalspannung 20 gebildet, diese also geglättet oder gemittelt. Zu der geglättete analogen Signalspannung 20 wird dann analogelektrisch die Schwellenspannung 30 addiert und die Summe beider Spannungen auf den zweiten Eingang des selbst umpolenden Komparators 26 gegeben.

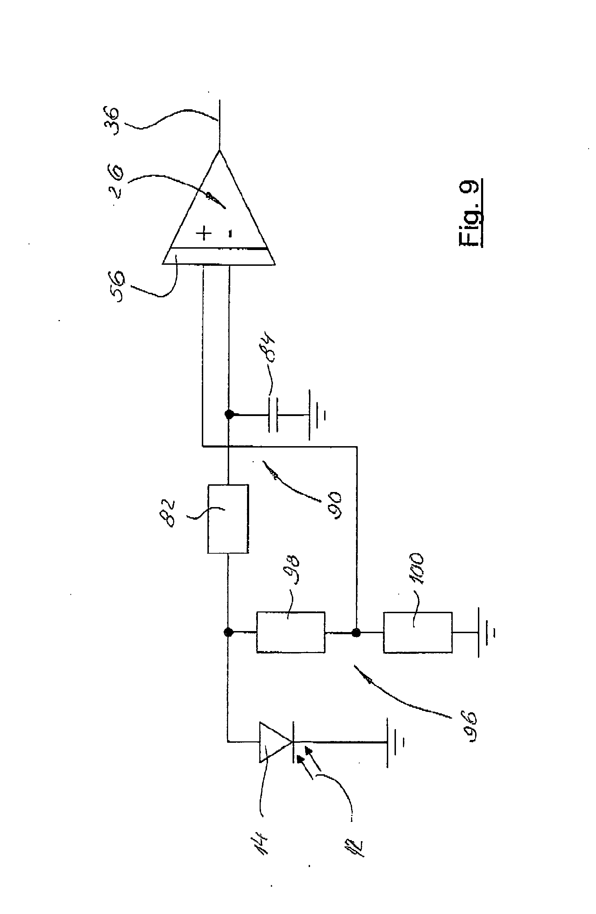

In Figur 9 ist schematisch ein Teilschaltbild eines fünften Ausführungsbeispiels einer integrierten Empfängerschaltung 10 einer Vorrichtung zur Datenübertragung mit einem analogen optoelektronischen Signal dargestellt. Diejenigen Elemente, die zu denen des vierten, in Figur 8 beschriebenen Aurführungsbeispiel ähnlich sind, sind mit denselben Bezugszeichen versehen, so dass bezüglich deren Beschreibung auf die Ausführungen zum vierten Ausführungsbeispiel Bezug genommen wird.

Bei dem fünften Ausführungsbeispiel ist die Fotodiode 14 mit einem ihrer Anschlüsse auf Masse gelegt und mit ihrem anderen Anschluss über einen ersten Knoten mit einem ersten Anschluss eines ersten Spannungsteiler-wider-standes 98 eines Spsrinungsteilers 96 verbunden. Der zweite Anschluss des ersten Spannungsteiler-Widerstandes 98 ist über einen zweiten Knoten, welcher als Abgriff des Spannungsteilers 96 wirkt, mit einem ersten Anschluss eines zweiten Spannungsteiler-Widerstandes 100 verbunden Der zweite Arschluss des zweiten Spannungsteiler-Widerstandes 100 liegt auf Masse.

Der zweite Knoten ist außerdem direkt mit dem ersten Eingang der Signalumpolung-Komparator-Anordnung 26 verbunden.

Ferner führt von dem ersten Knoten eine Verbindung zu einem ersten Anschluss eines Tiefpaaa-Widerstandes 82, der zu einem als Tiefpass 90 wirkenden RC-Glied gehört. Der zweite Arschluss des Tiefpass-Widerstandes 82 führt über einen dritten Knoten, welcher als Ausgang des Tiefpasses 90 dient, zu dem zweiten Eingang des umpolenden Komparators. Der dritte Knoten ist darüber hinaus über den Kondensator 84 des Tiefpasses 90 mit der Masse verbunden.

Bei der Vorrichtung gemäß dem fünften Ausführungsbeispiel wird die Fotodiode 14 im Generatormodus betrieben und die so erzeugte Spannung, welche beispielsweise im Bereich von 0,4 V bis 0,8 V, aber auch darunter oder darüber liegen kann, als analoge Signalspannung 20 eingesetzt. Die so erzeugte analoge Signalspannung 20 wird zunächst einem Spannungsteiler 96 zugeführt. Das Verhältnis der Werte von Spannungsteiler-Widerständen 96 und 100 ist so vorgegeben, dass beispielhaft etwa 98% der analogen Signalspannung 20 an dem Abgriff des Spannungsteilers anliegen und damit an dem ersten Eingang des umpolenden Komparators 26 angelegt sind. Der Spannungsteiler 96 kann auch ein anderes Spannungsteilungsverhältnis aufweisen.

Die ungeteilte analoge Signalspannung 20 wird über den Tiefpass 90, mit dem der Mittelwert der analogen Signalspannung 20 gebildet, diese also geglättet wird, an den zweiten Eingang des umpolenden Komparators 26 angelegt. So wird die effektive, in Figur 9 nicht gezeigte, Schwellenspannung bei den hier lediglich beispielhaft gewählten Zahlenwerten mit 2% der je nach Grundlicht, also Intensität des vom Sender kommenden Lichts, im Bereich von 0,4 V bis 0,8 V liegenden analogen Signalspannung 10, also mit 8 mV bis 16 mV, vorgegeben.

Die Empfängerschaltungen 10 können statt mit einem verbrauchsmessgerät auch mit einem andersartigen mobilen oder ortsfesten elektronischen Gerät mit Netz- oder Batteriebetrieb, insbesondere mit einem Mobiltelefon, einem mobilen oder ortsfesten Rechner, insbesondere einem Notebook oder einem PC, verbunden oder in dieses integriert sein.

Anstelle des analogen Komparators 26 kann auch ein andersartiges Vergleicher-Mittel, auch in Form einer entsprechenden Software und/oder Schaltung eines Mikroprozessors, zum Vergleichen des analogen Signals, insbesondere der analogen Signalspannung 2C Verwendung finden. Anstelle der Signalspannung 20 und der Schwellenspannung 30 können dann auch andersartige Signal- beziehungsweise #Schwellwerte, beispielsweise Ströme oder Widerstände, miteinander verglichen werden.

Statt der infraroten Lichtsignale können mit entsprechenden Senderbauelementen und Empfängerbauelementen auch andersartige, insbesondere sichtbare, Lichtsignale oder auch Funksignale zur Kommunikation eingesetzt werden.

Das Lichtsignal kann statt binär auch über eine andere vorgegebene begrenzte Dauer-ZUSTANDS-Zeit auch andersartig kodiert sein. Das Lichtsignal kann statt in ein binäres Signal 34 auch in ein anderes digitales Signal umgewandelt werden.

Die Empfängerschaltung 10 kann statt der Fotodiode 14 ein andersartiges Empfängerbauelement, insbesondere einen Fotowiderstand, einen Fototransistor oder eine Fotozelle augfweisen.

Die Empfängerschaltung 10 kann auch mit einem Sendebaustein, der beispielsweise eine Infrarot-LED aufweist, die einen eingebauten Impulsformen umfaßt, in einen optoelektronischen Transceiverbaustein integriert sein. Im Sender kann dann auch eine bekannte schaltbare Konstantstromquelle integriert sein. Durch paarweise Anordnung von solchen optoelektronischen Transceiverbaueteinen ist eine komplette bidirektionale Übertragungsstrecke mit einer Reichweite wenigstens im Bereich von 2 m realisierbar.

Statt mit dem den Schwellwertgenerator 30 bildenden Spannungsteiler aus der Geräte-Versorgungsspannucg des Verbrauchsmessgerätes kann auch mit einer anderen Spannungsquelle die Schwellenspannung vorgegeben werden.

## Patentansprüche

1. Verfahren zur Datenübertragung, bei dem wenigstens
ein impulsförmiges analoges Signal (20), welches die zu übertragenden Daten charakterisiert, mit vorgegebener begrenzter ZUSTANDS-Zeit in ein digitales signal umgewandelt wird, bei dem das analoge Signal (20) mit einem vorgegebenen analogen Schwellwert (30) verglichen wird und ein binäres Ausgangssignal (34) solange erzeugt wird, solange der Vergleich ergibt, dass eine Amplitude des analogen Signals (20) größer als der Schwellwert (30) ist, **dadurch gekennzeichnet, dass** die das analoge Signal (20) und der Schwellwert (30)vertauscht werden, wenn das binäre Ausgangssignal (34) länger erzeugt wird als eine vorgegebene maximale Dauer-ZUSTANDS-Zeit für das binäre Ausgangssignal (34).

2. Verfahren nach Anspruch 1, **dadurch gekennzeichnet,**
**dass** das analoge Signal (20) mit einem analogelektrischen Komparator (26) mit dem analogen Schwellwert (30) verglichen wird und das vertauschen von analogem Signal (20) und Schwellwert (30) mit einer steuerbaren Signalvertauschungseinrichtung (56) geändert wird.

3. Verfahren nach Anspruch 1 oder 2, **dadurch gekennzeichnet, dass** die Datenübertragung mit Bit- und/oder Byte-orientierten Protokollen organisiert wird.

4. Verfahren nach Anspruch 3, dadurch gekermzeichnet,
dass die maximale Dauer-ZUSTANDS-Zeit von dem Bit-und/oder Byte-orientierten Protokoll vorgegeben wird.

5. Verfahren nach einem der Ansprüche 1 bis 4, **dadurch**
**gekennzeichnet, dass** eine Überschreitung der maximalen Dauer-ZUSTANDS-Zeit mit einem retriggerbaren monoflop (74) und einem nachgeschalteten Flipflop (76) erkannt wird.

6. Verfahren nach einem der Ansprüche 1 bis 4, **dadurch**
**gekennzeichnet, dass** die Überschreitung der maximalen Dauer-ZUSTANDS-Zeit und die Änderung der Polarität des analogen Signals (20) insbesondere durch eine Digitalschaltung (54, 66) oder eine Software eines Mikrocontrollers oder Mikroprozessors, insbesondere eines dem Komparator (26) nachgeschalteten oder in den Komparator (26) und/oder die analogelektrische Signalvertauschungseinrichtung (56) integrierten Zeitüberwachungskreises (54) oder eines Mikrocontrollers oder Mikroprozessors, realisiert wird.

7. Verfahren nach Anspruch 6, **dadurch gekennzeichnet, dass** zur Änderung der Polarität des analogen Signals (20) das binäre Ausgangssignal (34) insbesondere mit der Digitalschaltung (54, 66) oder der Software des Mikrocontrollers oder Mikroprozessors invertiert wird und mit dem invertierten Ausgangssignal die Änderung der Polarität des analogen Signals (20) realisiert wird, indem die analogelektrische Signalvertauschungseinrichtung (56) entsprechend angesteuert wird.

8. Verfahren nach einem der vorhergehenden Ansprüche,
**dadurch gekennzeichnet, dass** die geänderte Polarität des analogen Signals (20) bis zu einer weiteren Überschreitung der maximalen Dauer-ZUSTANDS-Zeit oder bis zur Erkennung eines Fehlers bei der Datenübertragung, insbesondere eines Fehlers im Bit- und/oder Byte-orientierten Protokoll, oder bis zur Erkennung eines Timingfehlers oder bis zu einer Kommunikationspause beibehalten wird.

9. Verfahren nach einem der Ansprüche 2 bis 8, **dadurch**
**gekennzeichnet, dass** die Änderung der Polarität des analogen Signals (20) mit einem entsprechenden Wechsel_ eines Logikpegels des digitalen Signals (34) gekoppelt ist.

10. Verfahren nach einem der vorhergehenden Ansprüche,
**dadurch gekennzeichnet, dass** für den analogen Schwellwert (30) ein Wert vorgegeben wird, der kleiner ist als ein maximaler Offset einer Komponente einer zur Durchführung des Verfahrens verwendeten Hardware, insbesondere eines Vergleicher-Bauteils (29), mit dem das analoge Signal (20) mit dem Schwellwert (30) verglichen wird.

11. Verfahren nach einem der vorhergehenden Ansprüche,
**dadurch gekennzeichnet, dass** gegebenenfalls enthaltene konstante oder langsam veränderliche Störanteile aus dem analogen Signal (20) insbesondere mit einem geeigneten analogelelctrischen Filter, insbesondere einem Hochpassfilter (80), vorzugsweise einem RC-Glied, zumindest teilweise eliminiert werden, bevor das analoge Signal (20) mit dem analogen Schwellwert (30) verglichen wird beziehungsweise bevor seine Polarität geändert wird (Figur 7).

12. Verfahren nach einem der Ansprüche 1 bis 10, **dadurch**
**gekennzeichnet, dass** das analoge Signal mit der Summe aus dem Schwellwert und dem geglätteten analogen Signal verglichen wird, insbesondere eine analoge Signalspannung (20) auf einen der beiden Eingänge der Signalvertauschungseinrichtung (56) und auf den anderen Eingang der Signalvertauschungseinrichtung (56) die durch einen Tiefpass (90), insbesondere ein RC-Glied, geglättete analoge Signalspannung (20) gegeben wird, vorzugsweise zuzüglich einer analogen Schwellwertapannung (Figur 8).

13. Verfahren nach einem der Ansprüche 1 bis 10, **dadurch**
**gekennzeichnet, dass** der Schwellwert als geglättete Amplitude des analogen Signals bestimmt wird und mit einem Bruchteil des nicht geglätteten analogen Signal verglichen wird, insbesondere ein Spannungsbruchteil (98, 100) der analogen Signalspannung (20) auf einen der beiden Eingänge der Signalvertauschungseirrichtung (56) gegeben wird, der der Komparator (26) nachgeschaltet ist, und auf den anderen Eingang der Signalvertauschungseinrichtung (56) die insbesondere mit einem Tiefpass (90) geglättete analoge optoelektronische Signalspannung (20) gegeben wird.

14. Verfahren nach einem der vorhergehenden Ansprüche,
**dadurch gekennzeichnet, dass** die Daten, insbesondere die Datenbits, der Datenübertragung durch Impulse mit einer mittleren Impulslänge von weniger als 25% einer Bitzeit kodiert werden.

15. Verfahren nach einem der vorhergehenden Ansprüche,
**dadurch gekennzeichnet, dass** die Daten, insbesondere die Datenbits, entsprechend der Quasinorm mit der Bezeichnung "IrDA" impulskodiert werden.

16. Verfahren nach einem der Ansprüche 1 bis 13, **dadurch**
**gekennzeichnet, dass** die Daten, insbesondere Datenbytes, entsprechende der ZVEI-Norm (IEC 1107) kodiert werden.

17. Verfahren nach einem der vorhergehenden Ansprüche,
**dadurch gekennzeichnet, dass** die Daten zwischen mindestens einem mobilen Gerät und einem ortsfesten oder zwischen zwei mobilen Geräten übertragen werden.

18. Verfahren nach einem der vorhergehenden Ansprüche,
**dadurch gekennzeichnet, dass** die Daten von und/oder zu einem insbesondere ortsfesten Verbrauchszähler, insbesondere einem Heizkosten-Verteiler oder einem Strom-, Gas-, Wasser- oder Wärmemengenzähler, übertragen werden.

19. Verfahren nach einem der Ansprüche 1 bis 18, dadurch
gekennzeichent, daß die analogen Signale auf optoelektronischem Weg erzeugt werden.

20. Vorrichtung zur Datenübertragung mit wenigstens
einem impulaförmigen analogen Signal, welches dic zu übertragenden Daten charakterisiert, wobei das analoge Signal eine vorgegebene begrenzte ZUSTANDS-Zeit hat, und mit einem Umwandler zur Umwandlung des analogen Signals in ein digitales, insbesondere binäres, Signal,
**dadurch gekennzeichnet, dass**
der Umwandler aufweist: ein Mittel (26) zum Vergleichen des analogen Signals (20) mit einem vorgegebenen analogen Schwellwert (30) und zur Erzeugung eines digitalen Ausgangssignals (34) dann, wenn die Amplitude des analogen Signals (20) größer als der analoge Schwellwert (30) ist; eine steuerbare analogelektrische Signalvertauschungseinrichtung (56), mit der die Polarität des analogen Signals (20) beim Erreichen einer vorgegebenen maximalen Dauer-ZUSTANDS-Zeit für das binäre Ausgangssignal (34) änderbar ist; und eine Umpol-Steuereinrichtung (54, 74-78), welche die Signalvertauschungseinrichtung jeweils in den anderen Schaltzustand stellt, wenn die ZUSTANDS-Zeit des analogen Signales die maximale Dauer-ZUSTANDS-Zeit erreicht.

21. Vorrichtung nach Anspruch 20, dadurch gekennzeich
net, dass das Vergleicher-Mittel ein analogelektrischer Komparator (26) ist und wenigstens ein Ausgang der Signalvertauschungseinrichtung (56) wenigstens einem Eingang des Komparators (26) vorgeschaltet ist.

22. Vorrichtung nach Anspruch 20 oder 21, dadurch ge
kennzeichnet, dass die Datenübertragung mit Bit-und/oder Byte-orientierten Protokollen organisiert ist.

23. Vorrichtung nach Anspruch 22, dadurch gekennzeich-
net, dass die begrenzte Dauer-ZUSTANDS-Zeit und die maximale Dauer-ZUSTANDS-Zeit von dem Bit- und/oder Byte-orientierten Protokoll vorgegeben sind.

24. Vorrichtung nach einem der Ansprüche 20 bis 23, da
durch gekennzeichnet, dass dem Umwandler, insbesondere dem Vergleicher-Mittel (26), ein retriggerbares Monoflop (74) und ein Flipflop (76) zur Erfassung einer Überschreitung der maximalen Dauer-ZUSTANDS-Zeit nachgeschaltet sind.

25. Vorrichtung nach einem der Ansprüche 20 bis 24, da
durch gekennzeichnet, dass eine Digitalschaltung oder ein Mikrocontroller oder Mikroprozessor mit einer Software zur Erfassung der Überschreitung der maximalen Dauer-ZUSTANDS-Zeit und zur Änderung der Polarität des analogen Signals (20), insbesondere eine dem Vergleicher-Mittel (26) nachgeschaltete oder in das Vergleicher-Mittel (26) und/oder in die Signalvertauschungseinrichtung (56) integrierte Zeit-Überwachungsschaltungschaltung (66) oder ein Mikrocontrollers oder Mikroprozessor, vorgesehen ist.

26. Vorrichtung nach Anspruch 25, dadurch gekennzeich
net, dass die Zeit-Überwachungsschaltung (66) beziehungsweise die Software des Mikrocontrollers oder Mikroprozessors ein Mittel (54) zum Invertieren des digitalen-Ausgangssignals (34) aufweist und die analogelektrische Signalvertauschungseinrichtung (59) mit der Zeit-Überwachungs-schaltung (66) beziehungsweise dem Mikrocontroller oder Mikroprozessor zur Änderung der Polarität des analogen optoelektronischen Signals (20) steuerbar verbunden ist.

27. Vorrichtung nach einem der Ansprüche 20 bis 26, ge
**kennzeichnet durch** ein Speichermittel, insbesondere einen Mikrocontrollers oder Mikroprozessor mit einer Software oder ein Flipflop (76) zum Halten der geänderten Polarität des analogen optoelektronischen Signals (20) bis zu einer weiteren Überschreitung der maximalen Dauer-ZUSTANDS-Zeit oder bis zur Erkennung eines Fehlers bei der Datenübertragung, insbesondere eines Fehlers im Bitbeziehungsweise Byte-orientierten Protokoll, oder bis zur Erkennung eines Timingfehlers oder bis zu einer Kommunikationspause.

28. Vorrichtung nach einem der Ansprüche 20 bis 27, da
durch gekennzeichnet, dass die Änderung der Polarität des analogen Signals (20) mit einem entsprechenden Wechsel eines Logikpegels des digitalen Signals (34) am Ausgang des Vergleicher-Mittels (26) gekoppelt ist.

29. Vorrichtung nach einem der Ansprüche 20 bis 28, da
durch gekennzeichnet, dass der analoge Schwellenwert (30) kleiner ist als ein maximaler Offset- des Vergleicher-Mittels, insbesondere des Komparators (26), insbesondere das analoge Signal (20) an einem ersten Eingang (24) des Vergleicher-Mittels (26) und der analoge Schwellwert (30) an einem zweiten Eingang (28) des Vergleicher-Mittels (26) anliegt.

30. Vorrichtung nach einem der Ansprüche 20 bis 29, da durch gekennzeichnet, dass dem Vergleicher-Mittel (14) und/oder der analogelektrischen Signalvertauschungseinrichtung (56) ein geeignetes analogelektrisches Filter, insbesondere ein Hochpassfilter, vorzugsweise ein RC-Glied (80), zum zumindest teilweisen Eliminieren gegebenenfalls enthaltener konstanter oder langsam veränderlicher Störanteile aus dem analogen optoelektronischen Signal (20), vorgeschaltet ist.

31. Vorrichtung nach einem der Ansprüche 20 bis 30, **dadurch gekennzeichnet, dass** dem Vergleicher-Mittel (26) und/oder der analogelektrische Signalvertauschungseinrichtung (56) ein Mittel zur Glättung des analogen Signals (20), insbesondere ein Tiefpass (90), vorzugsweise ein RC-Glied, und ein Mittel zum Addieren des Schwellwertes (30) und des am Ausgang des Tiefpasses (90) anliegenden geglätteten analogen optoelektronischen Signals (20) vorgeschaltet sind, insbesondere das analoge Signal (20) gleichzeitig an einem der beiden Eingänge der Signalvertauschungseinrichtung (56) mit dem nachgeschalteten Vergleicher-Mittel (26) und am Eingang des Tiefpasses (90) anliegt, wobei der Tiefpass (90) und ein Mittel (30) zur Erzeugung einer den analogelektrischen Schwellwert charakterisierenden Schwellenspannung dem anderen Eingang der Signalvertauschungseinrichtung (56) in Reihe vorgeschaltet sind.

32. Vorrichtung nach einem der Ansprüche 20 bis 29, da
durch gekennzeichnet, dass einem ersten Eingang (24) des Vergleicher-Mittels (26) und/oder der analogelektrischen Signalvertauschungseinrichtung (56) ein Mittel (96) zur Bildung eines Amplitudenbruchteils des analogen Signals (20), insbesondere ein Spannungsteiler (96), vorgeschaltet ist und einem zweiten Eingang (28) des Vergleicher-Mittels (26) und/oder der analogelektrischen Signalvertauschungseinrichtung (56) ein Mittel zur Glättung des analogen optoelektronischen Signals (20), insbesondere ein Tiefpass (90), vorgeschaltet ist.

33. Vorrichtung nach einem der Ansprüche 20 bis 32, da
durch gekennzeichnet, dass die Daten, insbesondere die Datenbits, der Datenübertragung Impulse mit einer mittleren Dauer von weniger als 25% einer Bitzeit umfassen.

34. Vorrichtung nach einem der Ansprüche 20 bis 33, da-
durch gekennzeichnet, dass die Daten, insbesondere, die Datenbits, entsprechend der Quasinorm mit der Bezeichnung "IrDA" impulskodiert sind.

35. Vorrichtung nach einem der Ansprüche 20 bis 34, da-
durch gekennzeichnet, dass die Daten, insbesondere Datenbytes, entsprechend der ZVEI-Norm (IEC 1107) kodiert sind.

36. Vorrichtung nach einem der Ansprüche 20 bis 35, da-
durch gekennzeichnet, dass sie mit einem mobilen Gerät oder einem ortsfesten Gerätes funktionell verbunden oder in dieses integriert ist.

37. Vorrichtung nach einem der Ansprüche 20 bis 36, da-
durch gekennzeichnet, dass sie insbesondere mit einem ortsfesten Verbrauchszähler, insbesondere einem Heizkosten-Verteiler oder einem Strom-, Gas-, Wasser- oder Wärmemengenzähler, funktionell verbunden oder in diesen integriert ist.

38. Vorrichtung nach einem der Anspräche 20 bis 37, da-
durch gekennzeichet, dass das analoge Signal von der Ausgangsspannung eines lichtempfindlichen Wandlers (14) abgeleitet ist, welcher Teil eines Optokoppler einer optischen Datenübertragungsstrecke ist.
